# EUROPÄISCHE PATENTSCHRIFT

(11) **EP 1 363 485 B1**
(45) Veröffentlichungstag und Bekanntmachung des Hinweises auf die Patenterteilung: **25.01.2012**
(21) Anmeldenummer: 02405396.9
(22) Anmeldetag: 16.05.2002
(51) Int. Cl.: H02G 5/10, H01H 9/52

(54) **Kühlelement**
Cooling device
Dispositif de refroidissement

(43) Veröffentlichungstag der Anmeldung: 19.11.2003
(73) Patentinhaber: ABB Schweiz AG, 5400 Baden (CH)
(72) Erfinder: Keller, Markus, 8057 Zürich (CH); Pleines, Marianne, 8404 Winterthur (CH); Kiefer, Jochen, 5415 Nussbaumen (CH); Schoenemann, Thomas, 5426 Lengnau (CH); Dominguez, Mercedes Calvo, 28039 Madrid (ES)
(74) Vertreter: ABB Patent Attorneys

(56) Entgegenhaltungen:
- DE-A- 3 629 976
- DE-A- 19 619 060
- DE-C- 19 727 912
- DE-C- 19 811 000
- US-A- 2 965 819
- US-A- 4 587 377
- US-A- 6 068 051
- US-A- 6 147 867
- US-A- 6 165 612
- US-B1- 6 255 719

## Beschreibung

### TECHNISCHES GEBIET

Die Erfindung geht aus von einem Kühlelement gemäss dem Oberbegriff des Anspruchs 1.

### STAND DER TECHNIK

Es ist bekannt, die Wärmeabfuhr aus elektrischen Betriebsmitteln mittels Kühlrippen zu verbessern. In der Regel werden die Kühlrippen einstückig an das Metallgehäuse des betreffenden Betriebsmittels, beispielsweise eines Schaltgerätes, angeformt, um so einen guten Wärmeübergang zu erreichen. Diese verbesserte Wärmeabfuhr erlaubt entweder eine höhere Strombelastung des Betriebsmittels oder die Einsparung von elektrisch leitfähigem Material. Nachteilig wirkt sich bei diesen direkt angeformten Kühlrippen aus, dass der elektrische Strom, welcher durch das Betriebsmittel fliesst, infolge von Stromverdrängungseffekten zum Teil auch durch die Kühlrippen fliesst und diese zusätzlich erwärmt. Für die Abführung dieser zusätzlichen Erwärmung wird ein gewisser Anteil der Kühlkapazität der Kühlrippen benötigt. Die Kühlrippen müssen demnach, um diese zusätzlich benötigte Kühlkapazität aufzubringen, grösser dimensioniert werden. Diese vergrösserten Kühlrippen haben zur Folge, dass zugleich die Abmessungen des Betriebsmittels vergrössert werden und damit dieses Betriebsmittel verteuert wird.

Eine gattungsgemässe Vorrichtung ist auch in der DE 2 707 205 offenbart.

Die Erfindung, wie sie im unabhängigen Anspruch gekennzeichnet ist, löst die Aufgabe, ein Kühlelement zu schaffen, welches eine verbesserte Kühlkapazität aufweist.

Dies wird dadurch erreicht, dass das Kühlelement konsequent nicht als Stromleiter verwendet wird. Das Kühlelement kann deshalb optimal für eine besonders gute Kühlkapazität ausgelegt werden. Das Kühlelement ist aus einem Metall oder einer Metallegierung gefertigt. Es weist mindestens eine Kühlrippe oder eine sonstige, die Oberfläche des Kühlelements vergrössernde, erhabene Struktur auf. Das Kühlelement ist mittels Befestigungsmitteln oder formschlüssig lösbar mit einem metallischen Gehäuse eines Betriebsmittels verbunden. Das Kühlelement ist mit einem wärmeleitenden und elektrisch isolierenden Überzug versehen, und weist das gleiche elektrische Potential auf wie das Gehäuse.

Der gut wärmeleitende Überzug besteht überwiegend aus einem Bornitrid- oder Aluminiumnitridpulver oder einem Gemisch der beiden Pulver. Ist das Kühlelement aus einer Aluminiumlegierung gefertigt, so wird es vorteilhaft mit einer Eloxalschicht als Überzug versehen. Bei diesem Kühlelement sind der Strompfad durch das Gehäuse und der Weg für die Ableitung der Wärme, trotz der innigen Berührung zwischen dem Gehäuse und dem Kühlelement, vollständig von einander getrennt.

Es ist durchaus vorstellbar, dass auch organische Stoffe für den elektrisch isolierenden und gut wärmeleitenden Überzug eingesetzt werden, der dann beispielsweise in Form eines Lackes durch Spritzen oder Tauchen aufgebracht wird.

Wird das Betriebsmittel forciert gekühlt, beispielsweise mittels einer Beblasung, so wird das Kühlelement strömungsgünstig ausgebildet und so gestaltet, dass eine möglichst grosse Oberfläche von der Kühlmittelströmung bestrichen wird, sodass eine möglichst wirksame Wärmeabfuhr gewährleistet ist.

Die Erfindung, ihre Weiterbildung und die damit erzielbaren Vorteile werden nachstehend anhand der Zeichnung, welche lediglich einen möglichen Ausführungsweg darstellt, näher erläutert.

### KURZE BESCHREIBUNG DER ZEICHNUNG

Es zeigen:
Fig.1a eine Draufsicht auf ein vereinfacht dargestelltes Kühlelement,
Fig. 1b einen Schnitt A-A durch das Kühlelement gemäss Fig. 1a, und
Fig. 2 einen Teilschnitt durch ein Gehäuse mit einer angeformten Fläche und das für die Montage auf dieser Fläche vorgesehene Kühlelement.
In den Figuren sind gleiche Elemente mit gleichen Bezugszeichen versehen. Alle für das unmittelbare Verständnis der Erfindung nicht erforderlichen Elemente sind nicht dargestellt bzw. nicht beschrieben.

### WEGE ZUR AUSFÜHRUNG DER ERFINDUNG

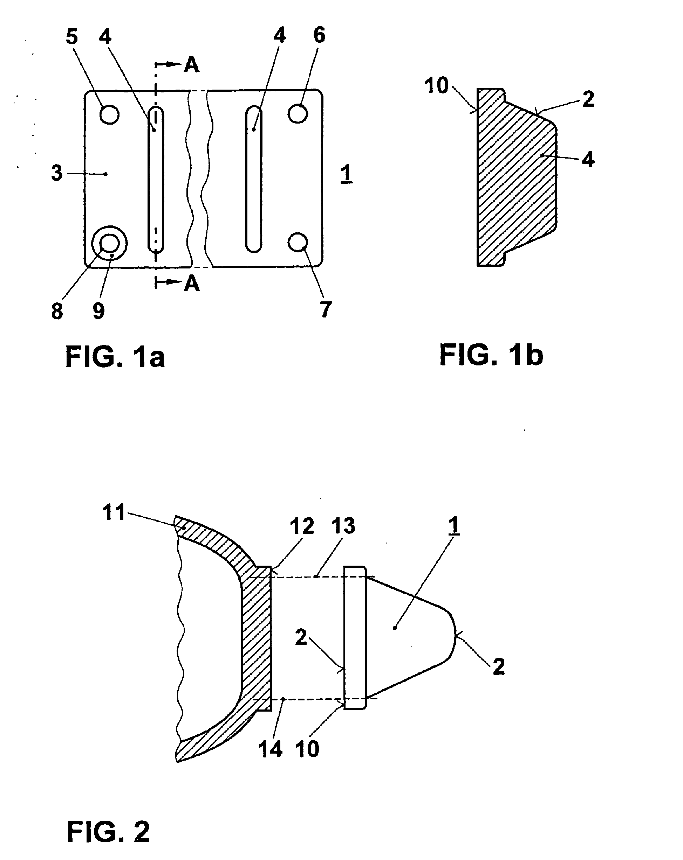

Die Figur 1a zeigt eine Draufsicht auf ein vereinfacht dargestelltes Kühlelement 1. Die Fig. 1b zeigt einen Schnitt A-A durch das in Fig. 1a dargestellte Kühlelement. Das Kühlelement 1 ist aus einem gut die Wärme leitenden Metall gefertigt, beispielsweise aus einem Aluminiumguss. Die gesamte Oberfläche des Kühlelements 1 ist mit einem elektrisch isolierenden, gut die Wärme leitenden Überzug 2 versehen. Der Überzug 2 kann beispielsweise überwiegend aus einem Bornitridoder Aluminiumnitridpulver bestehen welches, zusammen mit Bindemitteln, auf die gesamte Oberfläche des Kühlelements 1 aufgetragen wird. Der Überzug 2 kann aber auch aus einem Gemisch der beiden Pulver bestehen. Bei einem aus Aluminiumguss gefertigten Kühlelement 1 wird die Oberfläche vorteilhaft mit einer Eloxalschicht überzogen. Diese Eloxalschicht weist vorzugsweise eine Schichtdicke von 15 bis 20 µm auf, ein Bereich von 10 bis 50 µm kann gute bis sehr gute elektrisch isolierende Eigenschaften haben und zugleich eine gute Wärmeleitfähigkeit bieten.

Das Kühlelement 1 weist eine Grundplatte 3 auf an die mindestens eine Kühlrippe 4 angeformt ist. Die Grundplatte 3 weist Bohrungen 5,6,7 und 8 auf, die für die nicht dargestellte Verschraubung des Kühlelements 1 mit dem zu kühlenden Betriebsmittel vorgesehen sind. Die Bohrung 8 weist eine diese Bohrung 8 umgebende Auflagefläche 9 auf. Auf dieser Auflagefläche 9 ist der Überzug 2 vollständig entfernt, sie ist metallisch blank. Wenn das Kühlelement 1 aus Aluminiumguss besteht, kann es sinnvoll sein, diese Auflagefläche 9 zu fetten, um eine Oxidbildung zu vermeiden. Es ist stets nur eine der Bohrungen 5,6,7 und 8 mit dieser metallisch blanken Auflagefläche 9 versehen. Auf der dem Betriebsmittel zugewandten Seite der Grundplatte 3 ist eine ebene Grundfläche 10 vorgesehen. Diese Grundfläche 10 ist ebenfalls vollständig mit dem jeweiligen Überzug 2 bedeckt.

Die Fig. 2 zeigt einen Teilschnitt durch ein metallisches, stromführendes Gehäuse 11 eines Betriebsmittels mit einer angeformten Montagefläche 12. Diese Montagefläche 12 ist metallisch blank ausgeführt. Mit dieser Montagefläche 12 wird das Kühlelement 1 verschraubt. Zwei gestrichelte Linien 13 und 14 deuten diese Verschraubung des Kühlelements 1 an. Die Oberfläche der Montagefläche 12 ist der Oberflächenform der Grundfläche 10 des Kühlelements 1 angepasst. Vorzugsweise werden ebene Oberflächenformen gewählt, es ist jedoch durchaus möglich, beispielsweise auch Zylinderflächen oder sonstige ballige Oberflächenformen vorzusehen. Ferner ist es beispielsweise möglich, das Kühlelement 1 in eine in die Oberfläche des Betriebsmittels eingeformte Nut einzuschieben, welche dann das Kühlelement 1 formschlüssig hält. Zusätzlich könnte in diesem Fall der Kontakt zwischen den Nutflanken und dem Kühlelement 1 mittels Federkraft verstärkt werden, was einen besseren Wärmeübergang zur Folge hätte.

In der Regel wird das Gehäuse 11 des Betriebsmittels mit einer Vielzahl von Montageflächen 12 versehen, es werden jedoch nur soviel Kühlelemente 1 auf diese Montageflächen 12 montiert, wie für die jeweils vorgesehene Strombelastung benötigt werden. Das Betriebsmittel kann demnach optimal an seine thermische Belastung angepasst werden. Wenn bei einem Betriebsmittel noch freie Montageflächen 12 vorhanden sind, so kann es mit wenig Montageaufwand nachträglich noch für eine höhere Strombelastung ertüchtigt werden. Als besonders vorteilhaft erweist es sich auch, dass freie Montageflächen 12 erlauben, nachträglich eine verbesserte Wärmeabfuhr zu erreichen, falls sich das im Betrieb als notwendig erweisen sollte. Auf diese Art kann die Betriebssicherheit der Anlage verbessert werden. Es ist auch möglich, die Strombelastbarkeit des Betriebsmittels dadurch zu erhöhen, dass die ursprünglich eingebauten Kühlelemente 1 durch neue Kühlelemente 1 ersetzt werden, die eine grössere Kühlwirkung entfalten können, da sie beispielsweise eine grössere kühlende Oberfläche oder eine grössere Anzahl Kühlrippen aufweisen.

Zur Erläuterung der Wirkungsweise werden die Figuren etwas näher betrachtet. Das Gehäuse 11 ist hier beispielsweise aus einem Aluminiumguss gefertigt und in der Regel eloxiert. Beim Eloxieren wird jedoch die Montagefläche 12 abgedeckt, sodass sie metallisch blank bleibt, etwaige Oxidhäute werden vor der Montage des Kühlelements 1 entfernt. Bei der Verschraubung, es sind auch andere Befestigungsmöglichkeiten vorstellbar, wird die gesamte Grundfläche 10 des Kühlelements 1 mit vergleichsweise grosser Kraft gegen diese Montagefläche 12 gedrückt, sodass sich ein inniger Berührungskontakt zwischen diesen beiden Flächen 10 und 12 ergibt, der einen guten Wärmeübergang vom Gehäuse 11 zum Kühlelement 1 ermöglicht. Die Grundfläche 10 ist elektrisch isolierend beschichtet, sodass trotz des innigen Berührungskontaktes kein elektrischer Strom vom Gehäuse 11 aus durch das Kühlelement 1 fliessen kann.

Das Kühlelement 1 besteht jedoch aus Metall, welches bei potentialfreier Befestigung undefinierte elektrische Ladungen tragen könnte. Um dies zu vermeiden, wird das Kühlelement 1 mit Hilfe der durch die Bohrung 8 geführten metallischen Schraube, deren Kopf auf der metallisch blanken Auflagefläche 9 aufliegt, mit dem Potential des Gehäuses 11 verbunden. Da stets nur eine der Schraubstellen eine derartige Auflagefläche 9 aufweist, ist gewährleistet, dass kein elektrischer Strom über die metallischen Schrauben durch das Kühlelement 1 hindurchfliessen kann. Bei dieser Ausführung des Kühlelements 1 sind der Strompfad durch das Gehäuse 11 und der Weg für die Ableitung der Wärme, trotz der innigen Berührung zwischen Gehäuse 11 und Kühlelement 1, vollständig von einander getrennt. Prinzipiell wäre es auch möglich, diese eine für die Potentialanbindung ausgebildete Schraubstelle einzusparen und durch eine punktförmige Verschweissung zu ersetzen. Die Potentialanbindung wäre auf diese Art ebenfalls sichergestellt.

### BEZEICHNUNGSLISTE

- 1: Kühlelement
- 2: Überzug
- 3: Grundplatte
- 4: Kühlrippe
- 5,6,7,8: Bohrungen
- 9: Auflagefläche
- 10: Grundfläche
- 11: Gehäuse
- 12: Montagefläche
- 13,14: gestrichelte Linien

## Patentansprüche

1. Kühlelement (1) aus einem Metall oder einer Metalllegierung mit mindestens einer Kühlrippe (4), welches mit einem metallischen Gehäuse (11) eines zu kühlenden Betriebsmittels, durch welches Betriebsmittel ein elektrischer Strom fliesst, der zu einer Erwärmung des Kühlelements (1) beiträgt, verbunden ist, wobei:
das Kühlelement (1) mit einem wärmeleitenden und elektrisch Isolierenden Überzug (2) versehen ist,
das Kühlelement (1) mit dem Gehäuse (11) des zu kühlenden Betriebsmittels mittels mehrerer Befestigungsmittel lösbar verbindbar ist,
das Kühlelement (1) das gleiche elektrische Potential aufweist wie das Gehäuse (11),
**dadurch gekennzeichnet,**
**dass** nur eines der Befestigungsmittel für die Potentialanblndung des Kühlelements (1) vorgesehen ist.

2. Kühlelement nach Anspruch 1, **dadurch gekennzeichnet,**
- **dass** der Überzug (2) überwiegend aus einem Bornitrid- oder Aluminiumnitridpulver oder einem Gemisch der beiden Pulver besteht.

3. Kühlelement nach Anspruch 1, **dadurch gekennzeichnet,**
- **dass** das Kühlelement (1) aus einer Aluminiumlegierung gefertigt und mit einer Eloxalschicht als Überzug (2) versehen ist.

4. Kühlelement nach Anspruch 3, **dadurch gekennzeichnet,**
- **dass** die Schichtdicke der Eloxalschicht im Bereich von 10 bis 50 µm liegt, vorzugsweise jedoch im Bereich von 15 bis 20 µm.

5. Kühlelement nach einem der Ansprüche 1 bis 4, **dadurch gekennzeichnet,**
- **dass** das metallische Gehäuse (11) des Betriebsmittels mindestens eine, einer beschichteten Grundfläche (10) des Kühlelements (1) angepasste Montagefläche (12) aufweist,
- **dass** die Montagefläche (12) metallisch blank ausgeführt ist, und
- **dass** die gesamte Grundfläche (10) des Kühlelements (1) gegen diese Montagefläche (12) gedrückt wird, sodass sich ein inniger Berührungskontakt zwischen diesen ergibt.

6. Kühlelement nach Anspruch 1, **dadurch gekennzeichnet,**
- **dass** der Strompfad durch das Gehäuse (11) und der Weg für die Ableitung der Wärme, trotz der innigen Berührung zwischen dem Gehäuse (11) und dem Kühlelement (1), vollständig von einander getrennt sind.

7. Kühlelement nach einem der Ansprüche 1 bis 6, **dadurch gekennzeichnet,**
- **dass** das Kühlelement in eine in die Oberfläche des Betriebsmittels eingeformte Nut zum formschlüssigen Halten des Kühlelementes (1) eingeschoben ist.

8. Kühlelement nach Anspruch 7, **dadurch gekennzeichnet,**
- **dass** der Kontakt zwischen den Nutflanken und dem Kühlelement (1) zum verbesserten Wärmeübergang mittels Federkraft verstärkt wird.

9. Betriebsmittel, durch das ein elektrischer Strom fliesst, der zu einer Erwärmung des Kühlelements (1) beiträgt, mit einem Gehäuse (11) und mit mindestens einem Kühlelement (1) nach einem der Ansprüche 5 bis 8, **dadurch gekennzeichnet,**
- **dass** das Gehäuse (11) mit einer Vielzahl von Montageflächen (12) versehen ist,
- auf den Montageflächen (12) eine Anzahl der Kühlelemente (1) montiert ist, welche benötigt werden, um für die jeweils vorgesehene Strombelastung das Betriebsmittel (1) optimal an seine thermische Belastung anzupassen.

## Claims

1. Cooling element (1) made of a metal or a metal alloy having at least one cooling rib (4) which is connected to a metal housing (11) for an operating means which is to be cooled, through which operating means an electric current is flowing and contributing to a heating of the cooling element (1),
the cooling element (1) is provided with a thermally conductive and electrically insulating coating (2),
the cooling element (1) can be detachably connected to the housing (11) for the operating means which is to be cooled by means of a plurality of fixing means,
the cooling element (1) has the same electrical potential as the housing (11),
**characterized**
**in that** only one of the fixing means is provided for the potential connection for the cooling element (1).

2. Cooling element according to Claim 1, **characterized**
- **in that** the coating (2) is made predominantly of a boron nitride or aluminum nitride powder or of a mixture of the two powders.

3. Cooling element according to Claim 1, **characterized**
- **in that** the cooling element (1) is made of an aluminum alloy and is provided with an anodized oxide layer as a coating (2).

4. Cooling element according to Claim 3, **characterized**
- **in that** the layer thickness of the anodized oxide layer is in the range from 10 to 50 µm, but is preferably in the range from 15 to 20 µm.

5. Cooling element according to one of Claims 1 to 4, **characterized**
- **in that** the metal housing (11) for the operating means has at least one mounting face (12) which is matched to a coated base (10) of the cooling element (1),
- **in that** the mounting face (12) is in the form of bare metal, and
- **in that** the entire base (10) of the cooling element (1) is pressed against this mounting face (12), so that internal touching contact is produced between the two.

6. Cooling element according to Claim 1, **characterized**
- **in that** the current path through the housing (11) and the channel for dissipating the heat are completely isolated from one another, despite the internal contact between the housing (11) and the cooling element (1).

7. Cooling element according to one of Claims 1 to 6, **characterized**
- **in that** the cooling element has been inserted into a groove made in the surface of the operating means for the purpose of holding the cooling element (1) with a form fit.

8. Cooling element according to Claim 7, **characterized**
- **in that** the contact between the groove edges and the cooling element (1) is reinforced by means of spring force for the purpose of improved heat transfer.

9. Operating means through which an electric current is flowing and contributing to a heating of the cooling element (1), having a housing (11) and having at least one cooling element (1) according to one of Claims 5 to 8, **characterized**
- **in that** the housing (11) is provided with a multiplicity of mounting faces (12),
- the mounting faces (12) have a number of the cooling elements (1) mounted on them, which cooling elements are required in order to optimally match the operating means (1) to its thermal load for the respectively provided current load.

## Revendications

1. Dispositif de refroidissement (1) en un métal ou un alliage métallique avec au moins une ailette de refroidissement (4), qui est assemblé à une enceinte métallique (11) d'un moyen de production à refroidir, par quel moyen de production un courant électrique circule et contribue à un réchauffement du dispositif de refroidissement (1),
dans lequel l'élément de refroidissement (1) est pourvu d'un revêtement (2) électriquement isolant et conducteur de la chaleur, l'élément de refroidissement (1) peut être assemblé de façon séparable à l'enceinte (11) du moyen de production à refroidir au moyen de plusieurs moyens de fixation, l'élément de refroidissement (1) présente le même potentiel électrique que l'enceinte (11), **caractérisé en ce qu'**il n'est prévu qu'un seul des moyens de fixation pour la liaison de potentiel de l'élément de refroidissement (1).

2. Elément de refroidissement selon la revendication 1, **caractérisé en ce que** le revêtement (2) se compose principalement d'une poudre de nitrure de bore ou de nitrure d'aluminium ou d'un mélange des deux poudres.

3. Elément de refroidissement selon la revendication 1, **caractérisé en ce que** l'élément de refroidissement (1) est fabriqué en un alliage d'aluminium et est pourvu d'une couche Eloxal comme revêtement (2).

4. Elément de refroidissement selon la revendication 3, **caractérisé en ce que** l'épaisseur de couche de la couche Eloxal se situe dans la plage de 10 à 50 µm, de préférence cependant dans la plage de 15 à 20 µm.

5. Elément de refroidissement selon l'une quelconque des revendications 1 à 4, **caractérisé en ce que**
- l'enceinte métallique (11) du moyen de production présente au moins une face de montage (12) adaptée à une face de base revêtue (10) de l'élément de refroidissement (1),
- la face de montage (12) se présente à l'état métallique nu, et
- toute la face de base (10) de l'élément de refroidissement (1) est pressée contre cette face de montage (12), de telle manière qu'il en résulte un contact physique étroit entre celles-ci.

6. Elément de refroidissement selon la revendication 1, **caractérisé en ce que** le chemin de courant à travers l'enceinte (11) et le parcours destiné à évacuer la chaleur sont complètement séparés l'un de l'autre, malgré le contact étroit entre l'enceinte (11) et l'élément de refroidissement (1).

7. Elément de refroidissement selon l'une quelconque des revendications 1 à 6, **caractérisé en ce que** l'élément de refroidissement est inséré dans une rainure formée dans la surface du moyen de production afin de maintenir l'élément de refroidissement (1) par complémentarité de forme.

8. Elément de refroidissement selon la revendication 7, **caractérisé en ce que** le contact entre les flancs de la rainure et l'élément de refroidissement (1) est renforcé par la force d'un ressort afin d'améliorer le transfert de chaleur.

9. Moyen de production par lequel un courant électrique circule et de contribue à un réchauffement du dispositif de refroidissement (1), avec une enceinte (11) et avec au moins un élément de refroidissement (1) selon l'une quelconque des revendications 5 à 8, **caractérisé en ce que**
- l'enceinte (11) est pourvue d'une pluralité de faces de montage (12),
- sur les faces de montage (12) est monté le nombre d'éléments de refroidissement (1) qui sont nécessaires pour adapter de façon optimale le moyen de production (1) à sa charge thermique pour la charge de courant respectivement prévue.
